# EUROPÄISCHE PATENTSCHRIFT

(11) **EP 3 469 624 B1**
(45) Veröffentlichungstag und Bekanntmachung des Hinweises auf die Patenterteilung: **20.04.2022**
(21) Anmeldenummer: 17728487.4
(22) Anmeldetag: 31.05.2017
(51) Int. Cl.: H01L 21/02, C23C 16/458, C30B 25/12, C30B 31/14, H01L 21/687, C30B 29/06

(54) **SUSZEPTOR ZUM HALTEN EINER HALBLEITERSCHEIBE, HALBLEITERSCHEIBE UND HERSTELLUNGSVERFAHREN**
SUSCEPTOR FOR HOLDING A SEMICONDUCTOR WAFER, SEMICONDUCTOR WAFER AND MANUFACTURING METHOD
SUPPORT POUR MAINTENIR UN SUBSTRAT SEMICONDUCTEUR, SUBSTRAT SEMICONDUCTEUR ET MÉTHODE DE FABRICATION

(30) Priorität: 09.06.2016 DE 102016210203
(43) Veröffentlichungstag der Anmeldung: 17.04.2019
(73) Patentinhaber: Siltronic AG, 81677 München (DE)
(72) Erfinder: HABERECHT, Jörg, 09599 Freiburg (DE)
(74) Vertreter: Staudacher, Wolfgang
(86) Internationale Anmeldenummer: PCT/EP2017/063089
(87) Internationale Veröffentlichungsnummer: WO 2017/211630

(56) Entgegenhaltungen:
- EP-A1- 1 460 679
- JP-A- 2011 144 091
- US-A- 6 129 047
- US-A1- 2007 227 441
- US-A1- 2009 031 954
- US-A1- 2012 309 175
- US-A1- 2013 263 776
- US-A1- 2013 264 690
- US-A1- 2015 275 395
- US-B1- 6 444 027

## Beschreibung

Gegenstand der Erfindung ist ein Suszeptor zum Halten einer Halbleiterscheibe während des Abscheidens einer epitaktischen Schicht auf einer Vorderseite der Halbleiterscheibe. Gegenstand der Erfindung sind des Weiteren ein Verfahren zum Abscheiden einer epitaktischen Schicht auf einer Vorderseite einer Halbleiterscheibe, im Zuge dessen der Suszeptor verwendet wird, sowie eine Halbleiterscheibe mit epitaktischer Schicht.

### Stand der Technik / Probleme

In US 2008/0118712 A1 ist ein Suszeptor beschrieben, umfassend einen Suszeptorring und einen Suszeptorboden. Der Suszeptorring hat einen Sims (ledge) zum Ablegen einer Halbleiterscheibe im Randbereich der Rückseite der Halbleiterscheibe und wird zum Abscheiden einer Schicht auf der Vorderseite der Halbleiterscheibe auf dem Suszeptorboden abgelegt.

In US 2007/0227441 A1 wird auf periodische Schwankungen der Dicke der epitaktischen Schicht im Randbereich von epitaktisch beschichteten Halbleiterscheiben aus Silizium hingewiesen. Grund sind unterschiedliche Wachstumsgeschwindigkeiten, mit denen die epitaktische Schicht wächst. Die unterschiedlichen Wachstumsgeschwindigkeiten stehen in einem Zusammenhang mit der Kristallorientierung der Vorderseite der Halbleiterscheibe. Die Vorderseite der Halbleiterscheibe ist diejenige Seitenfläche der Halbleiterscheibe, auf der die epitaktische Schicht abgeschieden wird. Um die Dicke der epitaktischen Schicht im Randbereich zu vergleichmäßigen, wird in US 2007/0227441 A1 vorgeschlagen, die Struktur des Suszeptors mit der Periode der Dickenschwankungen zu verändern.

Mit derselben Zielsetzung wird in US 2013/0263776 vorgeschlagen, Löcher im Suszeptor an Stellen zusätzlich anzuordnen, die symmetrisch am Umfang des Suszeptors außerhalb des Radius einer auf dem Suszeptor abgelegten Halbleiterscheibe liegen.

Die Dokumente US2015/0275395-A1, EP1460679-A1, US2004/0144323-A1 und JP2011144091-A offenbaren ebenfalls Suszeptoren für Halbleiterscheiben und Verfahren aus dem Stand der Technik.

Aufgabe der vorliegenden Erfindung ist es, die Ebenheit von Halbleiterscheiben mit abgeschiedener epitaktischer Schicht im Randbereich durch Modifizieren des Suszeptors zu verbessern, ohne auf die Dicke der epitaktischen Schicht einwirken zu müssen. Insbesondere wird ein Weg aufgezeigt, der den Randabfall (edge roll-off, ERO) durch das Abscheiden der epitaktischen Schicht nicht vergleichmäßigt.

Gelöst wird die Aufgabe durch ein Verfahren zum Abscheiden einer epitaktischen Schicht auf einer Vorderseite einer Halbleiterscheibe, umfassend das Bereitstellen der Halbleiterscheibe;
das Anordnen der Halbleiterscheibe auf dem Sims eines Suszeptorrings eines erfindungsgemäßen Suszeptors, wobei der Suszeptorboden eine Anzahl von Vertiefungen aufweist, die einer Anzahl an ersten von zwei, sich abwechselnden Teilbereichen des Randbereichs der Vorderseite der Halbleiterscheibe entspricht, und eine Aufwachsrate der epitaktischen Schicht wegen einer Kristallorientierung der Vorderseite in den ersten Teilbereichen geringer ist, als in den zweiten Teilbereichen, derart, dass die ersten Teilbereiche über den Vertiefungen im Suszeptorboden liegen; und das Abscheiden der epitaktischen Schicht auf der Vorderseite der Halbleiterscheibe.

Gegenstand der Erfindung ist schließlich eine Halbleiterscheibe mit epitaktischer Schicht, wobei die Dicke der epitaktischen Schicht in ersten Teilbereichen des Randbereichs der Halbleiterscheibe mit epitaktischer Schicht dünner ist, als in zweiten Teilbereichen des Randbereichs, und Matrialabscheidungen auf der Rückseite der Halbleiterscheibe vorhanden sind, durch die die Gesamtdicke, die die Halbleiterscheibe mit epitaktischer Schicht in den ersten Teilbereichen hat, angeglichen ist, an die Gesamtdicke, die die Halbleiterscheibe mit epitaktischer Schicht in den zweiten Teilbereichen hat.

Die Halbleiterscheibe hat eine lokale Ebenheit im Randbereich mit einem maximalen ESFQR-Wert von nicht mehr als 12 nm bei einem Randausschluss von 2 mm, vorzugsweise von nicht mehr als 10 nm bei einem Randausschluss von 2 mm.

Die Halbleiterscheibe oder zumindest ein die Oberfläche der Halbleiterscheibe umfassender Teil davon ist einkristallin und besteht vorzugsweise aus Silizium, Germanium oder aus einer Mischung dieser Elemente. Die Halbleiterscheibe kann vollständig aus einem der genannten Materialien bestehen. Es kann aber auch eine SOI-Scheibe (silicon on insulator), eine gebondete Halbleiterscheibe oder eine Substratscheibe sein, die bereits mit einer oder mehreren epitaktischen Schichten beschichtet worden ist. Die epitaktische Schicht besteht vorzugsweise aus Silizium, Germanium oder aus einer Mischung dieser Elemente, und enthält gegebenenfalls Dotierstoff.

Die Halbleiterscheibe kann von einem Einkristall abgetrennt werden, der nach der FZ-Methode (float zone) oder nach der CZ-Methode kristallisiert wurde. Die CZ-Methode umfasst das Eintauchen eines Keimkristalls in eine Schmelze, die in einem Tiegel enthalten ist, und das Anheben des Keimkristalls und des daran kristallisierenden Einkristalls von der Schmelze.

Die Halbleiterscheibe hat einen Durchmesser von mindestens 200 mm, vorzugsweise mindestens 300 mm. Die Vorderseite der Halbleiterscheibe ist vorzugsweise <100>-orientiert oder <110>-orientiert.

Im Fall der <100>-Orientierung der Vorderseite kann der Randbereich der Vorderseite der Halbleiterscheibe in jeweils vier, sich abwechselnde erste und zweite Teilbereiche gegliedert werden. In den vier ersten Teilbereichen ist die Aufwachsrate einer epitaktischen Schicht geringer, als in den vier zweiten Teilbereichen des Randbereichs. Die Mitten der ersten Teilbereiche haben jeweils eine Winkelposition θ bezüglich des Umfangs der Halbleiterscheibe. Kennzeichnet eine Orientierungskerbe (notch) eine <110>-Richtung senkrecht zur <100>-Orientierung der Vorderseite der Halbleiterscheibe und wird dieser Richtung die Winkelposition θ von 270° zugeordnet, haben die Mitten der vier ersten Teilbereiche eine Winkelposition θ von 45°, 135°, 225° beziehungsweise 315°, entsprechend den Winkelpositionen der <100>-Richtungen senkrecht zur <100>-Orientierung der Vorderseite der Halbleiterscheibe.

Im Fall der <110>-Orientierung der Vorderseite kann der Randbereich der Vorderseite der Halbleiterscheibe in jeweils zwei, sich abwechselnde Teilbereiche gegliedert werden. In den zwei ersten Teilbereichen ist die Aufwachsrate einer epitaktischen Schicht auf der Vorderseite der Halbleiterscheibe geringer, als in den zwei zweiten Teilbereichen des Randbereichs. Kennzeichnet die Orientierungskerbe eine <110>-Richtung senkrecht zur <110>-Orientierung der Vorderseite der Halbleiterscheibe und wird dieser Richtung die Winkelposition θ von 270° zugeordnet, haben die Mitten der zwei ersten Teilbereiche eine Winkelposition θ von 0° beziehungsweise 180°, entsprechend den Winkelpositionen der <100>-Richtungen senkrecht zur <110>-Orientierung der Vorderseite der Halbleiterscheibe.

Während des Abscheidens einer epitaktischen Schicht auf der Vorderseite der Halbleiterscheibe liegt die Halbleiterscheibe auf dem Sims des Suszeptorrings und der Suszeptorring auf der oberen Ablagefläche des Suszeptorbodens. Die Halbleiterscheibe ist so angeordnet, dass die ersten Teilbereiche des Randbereichs der Vorderseite der Halbleiterscheibe, in denen die Aufwachsrate wegen der Kristallorientierung der Vorderseite geringer ist, über den Vertiefungen im Suszeptorboden liegen.

Ein Merkmal der Erfindung beinhaltet das Ablegen des Suszeptorrings auf der oberen Ablagefläche des Suszeptorbodens und nachfolgend das Ablegen der Halbleiterscheibe auf dem Sims des Suszeptorrings so, dass die Halbleiterscheibe in der geforderten Weise angeordnet ist. Ein alternatives Merkmal der Erfindung beinhaltet das Ablegen der Halbleiterscheibe auf dem Sims des Suszeptorrings und nachfolgend das Ablegen des Suszeptorrings mit der auf dem Sims liegenden Halbleiterscheibe auf der oberen Ablagefläche des Suszeptorbodens so, dass die Halbleiterscheibe in der geforderten Weise angeordnet ist.

Der Suszeptorboden besteht vorzugsweise aus Graphit-Filz oder aus Graphit-Filz, der mit Siliziumcarbid beschichtet ist, oder aus Graphit, der mit Siliziumcarbid beschichtet ist, oder aus Siliziumcarbid, der Suszeptorring vorzugsweise aus Siliziumcarbid oder aus einem anderen Material, das mit Siliziumcarbid beschichtet ist. Bei dem anderen Material handelt es sich vorzugsweise um Graphit oder Silizium. Der Suszeptorring hat einen Innendurchmesser und einen Außendurchmesser. Der Innendurchmesser ist kleiner und der Außendurchmesser ist größer, als der Durchmesser der Halbleiterscheibe, auf deren Vorderseite eine epitaktische Schicht abzuscheiden beabsichtigt ist. Die radiale Breite des Suszeptorrings entspricht der Hälfte der Differenz von Außendurchmesser und Innendurchmesser des Suszeptorrings. Der Sims des Suszeptorrings erstreckt sich vom inneren Rand des Suszeptorrings bis zu einer Stufe, die die Höhe des Suszeptorrings vergrößert. Der Sims ist vorzugsweise von der Stufe nach innen abfallend geformt.

Die Vertiefungen im Suszeptorboden sind rotationssymmetrisch verteilt angeordnet. Sie haben jeweils eine radiale Breite und sind vorzugsweise in den Suszeptorboden gefräst.

Die radiale Breite der Vertiefung ist jeweils größer, als die radiale Breite des Suszeptorrings, vorzugsweise um nicht weniger als 10 mm und nicht mehr als 100 mm. Aus diesem Grund bedeckt der Suszeptorring die Vertiefungen nicht vollständig. Wegen der Vertiefungen wird beim Abscheiden der epitaktischen Schicht auf der Vorderseite der Halbleiterscheibe zusätzlich auch Material auf der Rückseite der Halbleiterscheibe abgeschieden. Erfindungsgemäß wird dafür gesorgt, dass der Ort der zusätzlichen Abscheidung im Wesentlichen unter den ersten Teilbereichen des Randbereichs der Vorderseite der Halbleiterscheibe liegt. Zwar wird auf der Vorderseite der Halbleiterscheibe eine epitaktische Schicht abgeschieden, die mit dem Defizit behaftet ist, dass die Dicke der epitaktischen Schicht in den ersten Teilbereichen des Randbereichs dünner ist, als den zweiten Teilbereichen.

Gleichwohl hat die Halbleiterscheibe mit abgeschiedener epitaktischer Schicht eine besonders einheitliche Gesamtdicke im Randbereich, weil das Defizit wegen des gezielten Abscheidens von zusätzlichem Material auf der Rückseite der Halbleiterscheibe an Bedeutung verliert.

Die radiale Position der zusätzlichen Abscheidung von Material im Randbereich der Rückseite der Halbleiterscheibe kann gezielt beeinflusst werden. Sie hängt von der Auswahl der Läge ab, mit welcher der Sims von der Halbleiterscheibe überdeckt wird. Je größer diese Länge ist, desto weiter innen ist die Position der Materialabscheidung. Die Länge der Überdeckung beträgt vorzugsweise nicht weniger als 0,5 mm und nicht mehr als 3 mm.

Die Vertiefungen im Suszeptorboden haben jeweils eine Breite in Umfangsrichtung, deren Größe durch einen Mittelpunktswinkel angegeben werden kann. Die beiden Radien von der Mitte des Suszeptorbodens zu den beiden Enden einer Vertiefung schließen den Mittelpunktswinkel der Vertiefung ein. Die Mitte einer Vertiefung liegt auf der Winkelhalbierenden des Mittelpunktwinkels.

Ist beabsichtigt, eine epitaktische Schicht auf einer Vorderseite der Halbleiterscheibe abzuscheiden, die eine <100>-Orientierung hat, beträgt der Mittelpunktswinkel der vier Vertiefungen im Suszeptorboden jeweils vorzugsweise 60° bis 70 °, besonders bevorzugt 65°. Die Halbleiterscheibe wird auf dem Sims des Suszeptorrings vorzugsweise derart angeordnet, dass die Mitten der vier ersten Teilbereiche des Randbereichs der Vorderseite der Halbleiterscheibe über den Mitten der vier Vertiefungen liegen.

Ist beabsichtigt, eine epitaktische Schicht auf einer Vorderseite der Halbleiterscheibe abzuscheiden, die eine <110>-Orientierung hat, beträgt der Mittelpunktswinkel der zwei Vertiefungen im Suszeptorboden jeweils vorzugsweise 90° bis 110 °, besonders bevorzugt 100°. Die Halbleiterscheibe wird auf dem Sims des Suszeptorrings vorzugsweise derart angeordnet, dass die Mitten der zwei ersten Teilbereiche des Randbereichs der Vorderseite der Halbleiterscheibe über den Mitten der zwei Vertiefungen liegen.

Die Vertiefungen im Suszeptorboden haben eine Tiefe von vorzugsweise nicht weniger als 0,3 mm und nicht mehr als 1,0 mm. Die Tiefe einer Vertiefung kann einheitlich sein. Bevorzugt ist jedoch, dass die Tiefe in Umfangsrichtung zu- und wieder abnimmt und der Querschnitt der Vertiefungen in dieser Richtung einen Umriss hat, der U- oder V-förmig ist.

Die bezüglich der vorstehend aufgeführten Ausführungsformen des erfindungsgemäßen Verfahrens angegebenen Merkmale können entsprechend auf die erfindungsgemäße Vorrichtung übertragen werden. Umgekehrt können die bezüglich der vorstehend ausgeführten Ausführungsformen der erfindungsgemäßen Vorrichtung angegebenen Merkmale entsprechend auf das erfindungsgemäße Verfahren übertragen werden. Diese und andere Merkmale der erfindungsgemäßen Ausführungsformen werden in der Figurenbeschreibung und in den Ansprüchen erläutert. Die einzelnen Merkmale können entweder separat oder in Kombination als Ausführungsformen der Erfindung verwirklicht werden. Weiterhin können sie vorteilhafte Ausführungen beschreiben, die selbstständig schutzfähig sind.

Die Erfindung wird nachfolgend unter Bezugnahme auf Zeichnungen weiter erläutert.

### Kurzbeschreibung der Figuren

**Fig. 1** ist eine, den Stand der Technik repräsentierende Abbildung, die die relative Anordnung eines Suszeptorbodens, eines Suszeptorrings und einer Halbleiterscheibe zeigt.
**Fig.2** und **Fig.3** zeigen Orientierungsmerkmale von Halbleiterscheiben mit (100)-Flächen-Orientierung der Vorderseite (Fig.2) und mit (110)-Flächen-Orientierung der Vorderseite (Fig.3).
**Fig.4** zeigt einen erfindungsgemäßen Suszeptorboden in Draufsicht.
**Fig.5** und **Fig.6** zeigen radiale Vertikalschnitte durch den Suszeptorboden an unterschiedlichen Stellen, Fig.5 Vertikalschnitte im Bereich zwischen zwei Vertiefungen im Suszeptorboden und Fig.6 Vertikalschnitte im Bereich einer Vertiefung im Suszeptorboden (Fig.6).
**Fig.7, Fig.8** und **Fig.9** zeigen bevorzugte Formen des Umrisses eines Querschnitts in Umfangsrichtung durch eine Vertiefung gemäß Fig.4.
**Fig.10** ist ein Diagramm, das die Ebenheit epitaktisch beschichteter Testscheiben im Randbereich zeigt. Im Diagramm aufgetragen sind die ESFQR-Werte über die Winkelposition θ.

### Liste der verwendeten Bezugszeichen

- **1**: Suszeptorboden
- **2**: Suszeptorring
- **3**: Sims
- **4**: Halbleiterscheibe
- **5**: Vertiefung
- **6**: Orientierungskerbe
- **7**: Hebestift-Bohrung
- **8**: innerer Rand der Vertiefung
- **9**: innerer Rand des Suszeptorrings
- **10**: obere Ablagefläche
- **11**: epitaktische Schicht
- **12**: Materialabscheidung
- **α**: Mittelpunktswinkel

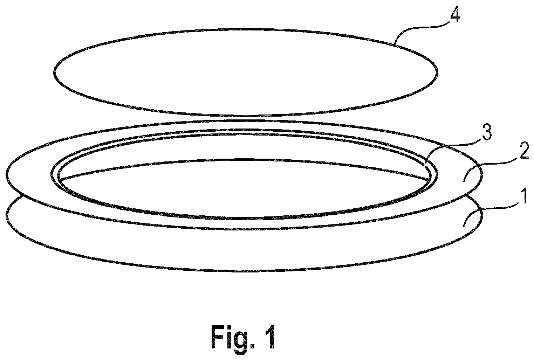

Die Anordnung gemäß **Fig.1** umfasst einen Suszeptorboden 1 und einen Suszeptorring 2 mit einem inneren Rand 9, an den sich nach außen ein Sims 3 anschließt. Auf dem Sims 3 kann eine Halbleiterscheibe 4 im Randbereich der Rückseite der Halbleiterscheibe abgelegt werden.

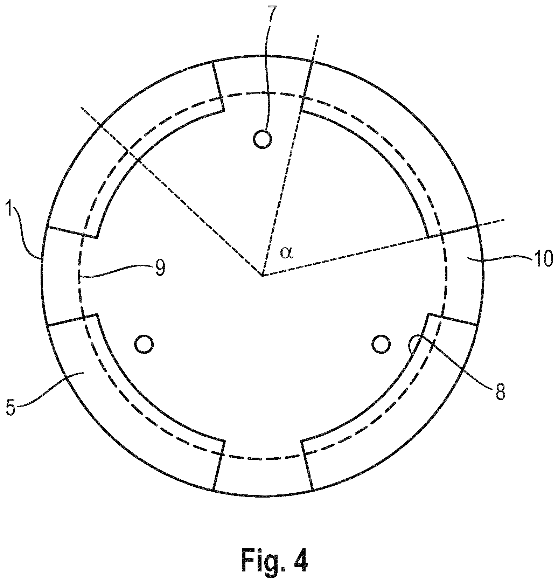

Im Suszeptorboden 1 gemäß **Fig.4** sind vier Vertiefungen 5 vorhanden, die auf der oberen Ablagefläche 10 des Suszeptorbodens 1 rotationssymmetrisch verteilt angeordnet sind, sowie Hebestift-Bohrungen 7 zum Anheben und Absenken der Halbleiterscheibe. Die Vertiefungen 5 haben jeweils einen inneren Rand 8 und eine Breite in Umfangsrichtung entsprechend der Größe des Mittelpunktswinkels a. Die Mitte einer Vertiefung liegt auf der Winkelhalbierenden (gepunktete Linie) des Mittelpunktwinkels. Die Anzahl der Vertiefungen entspricht der Anzahl von vier Teilbereichen des Randbereichs der Vorderseite einer Halbleiterscheibe, in denen die Aufwachsrate der epitaktischen Schicht wegen der Kristallorientierung der Vorderseite geringer ist, als in den Teilbereichen zwischen den vier Teilbereichen.

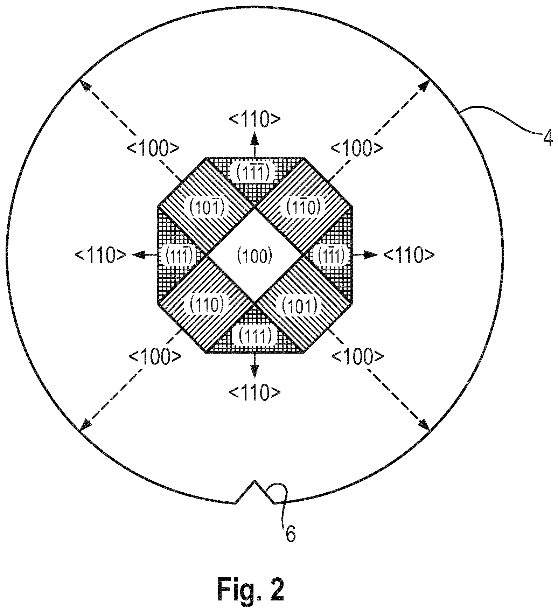

**Fig.2** zeigt Orientierungsmerkmale einer solchen Halbleiterscheibe 4 mit <100>-Orientierung der Vorderseite. Die Orientierungskerbe 6 markiert eine Winkelposition θ von 270°. Dementsprechend befinden sich die Mitten der vier Teilbereiche des Randbereichs mit geringerer Aufwachsrate der epitaktischen Schicht an den Winkelpositionen 45°, 135°, 225° und 315°, zu denen die Spitzen der gestrichelten Pfeile zeigen.

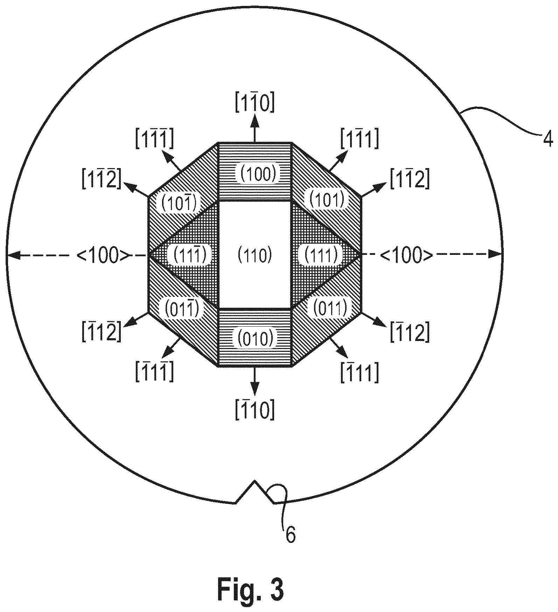

**Fig.3** zeigt Orientierungsmerkmale einer Halbleiterscheibe 4 mit <110>-Orientierung der Vorderseite. Die Orientierungskerbe 6 markiert eine Winkelposition θ von 270°. Dementsprechend befinden sich die Mitten der zwei Teilbereiche des Randbereichs mit geringerer Aufwachsrate der epitaktischen Schicht an den Winkelpositionen 0°, und 180°, zu denen die Spitzen der gestrichelten Pfeile zeigen.

Zum Abscheiden einer epitaktischen Schicht 11 auf einer Vorderseite der Halbleiterscheibe wird die Halbleiterscheibe 4 mit <100>-Orientierung der Vorderseite auf dem Sims 3 des Suszeptorrings 2 derart angeordnet, dass die vier ersten Teilbereiche über den vier Vertiefungen 5 im Suszeptorboden 1 liegen, vorzugsweise so, dass die Mitten der vier ersten Teilbereiche über den Mitten der vier Vertiefungen liegen.

Zum Abscheiden einer epitaktischen Schicht auf einer Vorderseite der Halbleiterscheibe wird die Halbleiterscheibe mit <110>-Orientierung der Vorderseite auf dem Sims des Suszeptorrings derart angeordnet, dass die zwei ersten Teilbereiche über den zwei Vertiefungen im Suszeptorboden liegen, vorzugsweise so, dass die Mitten der zwei ersten Teilbereiche über den Mitten der zwei Vertiefungen liegen.

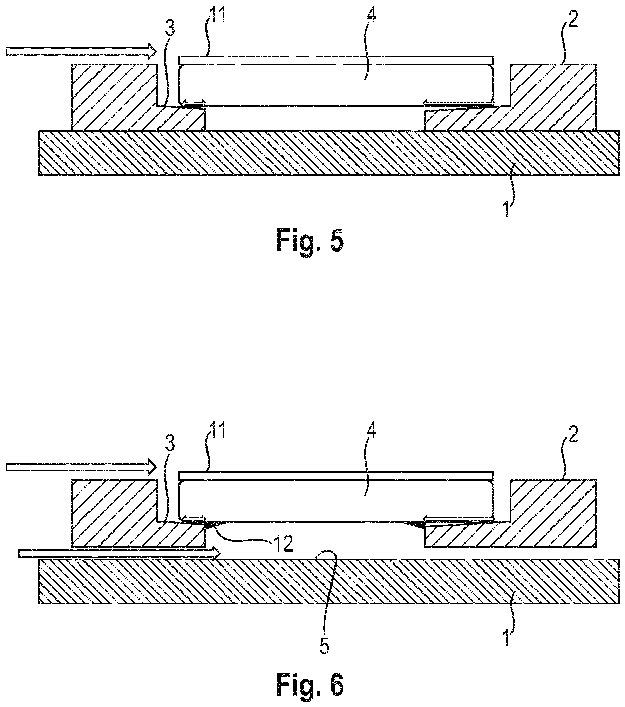

**Fig.6** zeigt einen Querschnitt in radialer Richtung durch die Mitte einer Vertiefung im Suszeptorboden, **Fig.5** den entsprechenden Querschnitt zwischen zwei Vertiefungen. Abscheidegas gelangt auf dem Weg, den der kürzere Pfeil andeutet, zur Vorderseite der Halbleiterscheibe 4, auf der die epitaktische Schicht 11 abgeschieden wird. Wegen der Vertiefung 5 ist ein weiterer Weg für das Abscheidegas vorhanden, der in Fig.6 durch den längeren Pfeil angedeutet ist und der unter dem Suszeptorring 2 hindurch zur Rückseite der Halbleitescheibe 4 führt, so dass Material 12 im Randbereich der Rückseite der Halbleiterscheibe 4 abgeschieden wird. Die Doppelpfeile bezeichnen die Länge der Überdeckung des Simses 3 durch die Halbleiterscheibe 4. Die radiale Position der Materialabscheidung 12 lässt sich durch die Auswahl der Länge der Überdeckung beeinflussen und wandert mit ansteigender Länge der Überdeckung nach innen. Die kürzere Überdeckung entsteht bei Verwendung eines Suszeptorrings 2 mit einem Sims 3 mit vergleichsweise kleiner radialer Breite, die größere Überdeckung durch Verwendung eines Suszeptorrings 2, dessen Sims 3 breiter ist.

Die Materialabscheidung 12 auf der Rückseite der Halbleiterscheibe 4 fehlt dort, wo der Suszeptorring 2 auf dem Suszeptorboden direkt aufliegt, weil keine Vertiefung vorhanden ist (Fig.5).

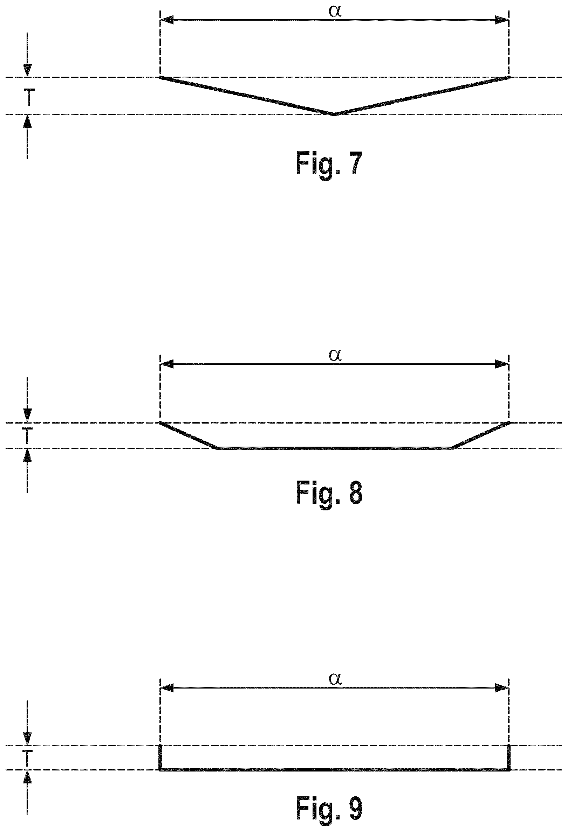

**Fig.7** zeigt den Querschnitt in Umfangsrichtung durch eine Vertiefung gemäß Fig.4. Der Umriss des Querschnitts ist V-förmig, weil die Tiefe T der Vertiefung entlang des Mittelpunktwinkels α von vorzugsweise 65° bis zu einem Maximum von 0,3 mm bis 1 mm ansteigt und wieder abnimmt, vorzugsweise linear ansteigt und abnimmt.

**Fig.8** zeigt den Querschnitt in Umfangsrichtung durch eine Vertiefung gemäß Fig.4 mit von Fig.7 abweichendem Umriss. Der Umriss des Querschnitts ist trapez-förmig, weil die Tiefe T der Vertiefung entlang des Mittelpunktwinkels α von vorzugsweise 65° bis zu einem Maximum von 0,3 mm bis 1 mm ansteigt, vorzugsweise linear ansteigt, über eine Strecke beim Maximum bleibt und wieder abnimmt, vorzugsweise linear abnimmt. Diese Form des Umrisses ist im Hinblick auf die Lösung der Aufgabe besonders bevorzugt.

**Fig.9** zeigt den Querschnitt in Umfangsrichtung durch eine Vertiefung gemäß Fig.4 mit von Fig.7 und Fig.8 abweichendem Umriss. Der Umriss des Querschnitts ist U-förmig, weil die Tiefe T der Vertiefung entlang des Mittelpunktwinkels α von vorzugsweise 65° bis zu einem Maximum von 0,3 mm bis 1 mm schnell ansteigt, beim Maximum bleibt und wieder schnell abnimmt, vorzugsweise sprunghaft ansteigt und abnimmt.

### Beschreibung erfindungsgemäßer Ausführungsbeispiele

Halbleiterscheiben aus einkristallinem Silizium mit einem Durchmesser von 300 mm und einer <100>-Orientierung der Vorderseite wurden in einem Einzelscheiben-Reaktor mit einer epitaktischen Schicht aus Silizium beschichtet. Ein Teil der Halbleiterscheiben (Vergleichsscheiben) wurde auf einem Suszeptor gemäß Fig.1 liegend beschichtet. Dem Suszeptorboden fehlten erfindungsgemäße Vertiefungen. Ein anderer Teil der Halbleiterscheiben wurde erfindungsgemäß beschichtet, also auf einem erfindungsgemäßen Suszeptor liegend. Die Mitten der vier Teilbereiche mit geringerer Aufwachsrate der epitaktischen Schicht lagen über den Mitten von vier Vertiefungen im Suszeptorboden.

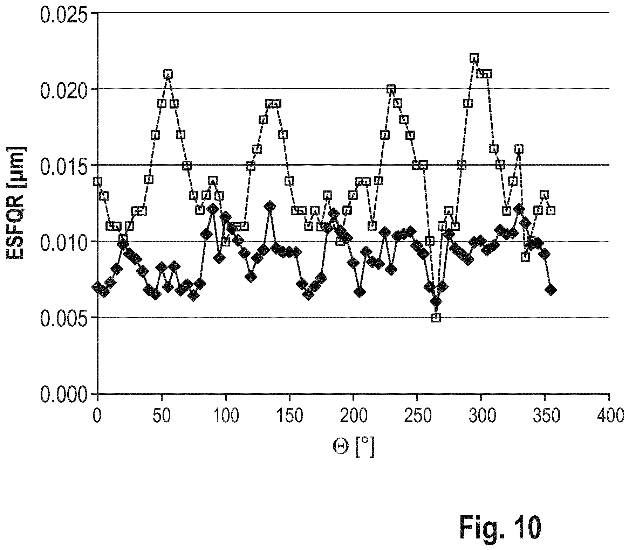

Im Anschluss wurde die lokale Ebenheit der beschichteten Halbleiterscheiben im Randbereich bestimmt. **Fig.10** zeigt ESFQR-Werte (Randausschluss 2 mm, Laser-Markierung bei θ = 265°, Sektor-Länge 30 mm) von jeweils einer der beschichteten Halbleiterscheiben des einen und des anderen Teils. Im Fall der erfindungsgemäß beschichteten Halbleiterscheibe zeigen die ESFQR-Werte (durchgezogene Linie) die charakteristischen periodischen Schwankungen nicht, während sie im Fall der Vergleichsscheibe zu sehen sind (gepunktete Linie).

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren. Daher sollen alle derartigen Abänderungen und Modifikationen sowie Äquivalente durch den Schutzbereich der Ansprüche abgedeckt sein.

## Patentansprüche

1. Verfahren zum Abscheiden einer epitaktischen Schicht auf einer Vorderseite einer Halbleiterscheibe (4), umfassend
das Bereitstellen eines Suszeptors umfassend einen Suszeptorring (2) und einen Suszeptorboden (1), wobei der Suszeptorring (2) um eine Mitte des Suszeptorbodens auf dem Suszeptorboden (1) liegt, und unter dem Suszeptorring (2) Vertiefungen (5) im Suszeptorboden (1) vorhanden sind, die auf dem Suszeptorboden (1) rotationssymmetrisch verteilt angeordnet sind und jeweils eine radiale Breite haben, die größer ist, als eine radiale Breite des Suszeptorrings (2);
das Bereitstellen der Halbleiterscheibe (4);
das Ablegen der Halbleiterscheibe (4) auf einem Sims (3) des Suszeptorrings (2) im Randbereich einer Rückseite der Halbleiterscheibe (4), wobei der Suszeptorboden (1) eine Anzahl von Vertiefungen (5) aufweist, die einer Anzahl an ersten von zwei, sich abwechselnden Teilbereichen des Randbereichs der Vorderseite der Halbleiterscheibe (4) entspricht, und eine Aufwachsrate der epitaktischen Schicht wegen einer Kristallorientierung der Vorderseite in den ersten Teilbereichen geringer ist, als in den zweiten Teilbereichen, derart, dass die ersten Teilbereiche über den Vertiefungen (5) im Suszeptorboden (1) liegen; und
das Abscheiden der epitaktischen Schicht auf der Vorderseite der Halbleiterscheibe (4).

2. Verfahren nach Anspruch 1, **gekennzeichnet durch** das Bereitstellen einer Halbleiterscheibe (4) mit <100>-Orientierung der Vorderseite und das Anordnen der Halbleiterscheibe über vier Vertiefungen (5) im Suszeptorboden (1).

3. Verfahren nach Anspruch 1, **gekennzeichnet durch** das Bereitstellen einer Halbleiterscheibe (4) mit <110>-Orientierung der Vorderseite und das Anordnen der Halbleiterscheibe über zwei Vertiefungen (5) im Suszeptorboden (1).

4. Verfahren nach einem der Ansprüche 1 bis 3, **gekennzeichnet durch** das Anordnen der Halbleiterscheibe (4) auf dem Sims (3) derart, dass der Sims (3) von der Halbleiterscheibe (4) über eine Länge von nicht weniger als 0,5 mm und nicht mehr als 3 mm überdeckt wird.

5. Verfahren nach Anspruch 1, **dadurch gekennzeichnet, dass** die Vertiefungen (5) im Suszeptorboden (1) die Form von Kreisring-Segmenten haben.

6. Verfahren nach Anspruch 5, **dadurch gekennzeichnet, dass** die Vertiefungen (5) einen Mittelpunktswinkel α haben, der nicht weniger als 60° und nicht mehr als 70° oder nicht weniger als 90° und nicht mehr als 110° beträgt.

7. Verfahren nach Anspruch 1, **dadurch gekennzeichnet, dass** der Querschnitt der Vertiefungen (5) in Umfangsrichtung des Suszeptorbodens (1) einen Umriss hat, der V-förmig ist.

8. Verfahren nach Anspruch 1, **dadurch gekennzeichnet, dass** der Querschnitt der Vertiefungen (5) in Umfangsrichtung des Suszeptorbodens (1) einen Umriss hat, der U-förmig ist.

9. Verfahren nach Anspruch 1, **dadurch gekennzeichnet, dass** der Querschnitt der Vertiefungen (5) in Umfangsrichtung des Suszeptorbodens (1) einen Umriss hat, der trapez-förmig ist.

10. Halbleiterscheibe (4) mit epitaktischer Schicht mit einer lokalen Ebenheit im Randbereich mit einem maximalen ESFQR-Wert von nicht mehr als 12 nm bei einem Randausschluss von 2 mm, wobei die Dicke der epitaktischen Schicht in ersten Teilbereichen des Randbereichs der Halbleiterscheibe (4) mit epitaktischer Schicht dünner ist, als in zweiten Teilbereichen des Randbereichs, und Matrialabscheidungen (12) auf der Rückseite der Halbleiterscheibe (4) vorhanden sind, durch die die Gesamtdicke, die die Halbleiterscheibe (4) mit epitaktischer Schicht in den ersten Teilbereichen hat, angeglichen ist, an die Gesamtdicke, die die Halbleiterscheibe (4) mit epitaktischer Schicht in den zweiten Teilbereichen hat.

## Claims

1. a method of depositing an epitaxial layer on a front surface of a semiconductor wafer (4), comprising
providing a susceptor comprising a susceptor ring (2) and a susceptor bottom (1), wherein the susceptor ring (2) lies around a center of the susceptor bottom on the susceptor bottom (1), and under the susceptor ring (2) there are depressions (5) in the susceptor bottom (1), which are arranged rotationally symmetrically distributed on the susceptor bottom (1) and each have a radial width which is greater than a radial width of the susceptor ring (2);
providing the semiconductor wafer (4);
placing the semiconductor wafer (4) on a ledge (3) of the susceptor ring (2) in the edge region of a back side of the semiconductor wafer (4), wherein the susceptor bottom (1) has a number of depressions (5) corresponding to a number of first of two alternating subregions of the edge region of the front side of the semiconductor wafer (4) and a growth rate of the epitaxial layer due to a crystal orientation of the front side is lower in the first sub-regions than in the second sub-regions, such that the first sub-regions are located above the depressions (5) in the susceptor bottom (1) and
the deposition of the epitaxial layer on the front side of the semiconductor wafer (4).

2. method according to claim 1, **characterized by** providing a semiconductor wafer (4) with <100> orientation of the front side and arranging the semiconductor wafer over four wells (5) in the susceptor bottom (1).

3. method according to claim 1, **characterized by** providing a semiconductor wafer (4) with <110> orientation of the front side and arranging the semiconductor wafer over two recesses (5) in the susceptor bottom (1).

4. a method according to any one of claims 1 to 3, **characterized by** arranging the semiconductor wafer (4) on the ledge (3) such that the ledge (3) is covered by the semiconductor wafer (4) over a length of not less than 0.5 mm and not more than 3 mm.

5. method according to claim 1, **characterized in that** the depressions (5) in the susceptor base (1) are in the form of circular ring segments.

6. method according to claim 5, **characterized in that** the depressions (5) have a center angle α which is not less than 60° and not more than 70° or not less than 90° and not more than 110°.

7. method according to claim 1, **characterized in that** the cross-section of the recesses (5) in the circumferential direction of the susceptor base (1) has an outline which is V-shaped.

8. method according to claim 1, **characterized in that** the cross-section of the recesses (5) in the circumferential direction of the susceptor base (1) has an outline which is U-shaped.

9. method according to claim 1, **characterized in that** the cross-section of the recesses (5) in the circumferential direction of the susceptor base (1) has an outline which is trapezoidal.

10. An epitaxial layer semiconductor wafer (4) having a local flatness in the edge region with a maximum ESFQR value of not more than 12 nm at an edge exclusion of 2 mm, the thickness of the epitaxial layer being thinner in first portions of the edge region of the epitaxial layer semiconductor wafer (4) than in second portions of the edge region, and matrix deposits (12) are provided on the back side of the semiconductor wafer (4), by which the total thickness that the epitaxial layer semiconductor wafer (4) has in the first portions is equalized to the total thickness that the epitaxial layer semiconductor wafer (4) has in the second portions.

## Revendications

1. procédé pour déposer une couche épitaxiale sur une face avant d'une plaquette semi-conductrice (4), comprenant
la mise à disposition d'un suscepteur comprenant un anneau de suscepteur (2) et un fond de suscepteur (1), l'anneau de suscepteur (2) se trouvant autour d'un centre du fond de suscepteur sur le fond de suscepteur (1), et des creux (5) étant présents dans le fond de suscepteur (1) sous l'anneau de suscepteur (2), lesquels sont répartis sur le fond de suscepteur (1) avec une symétrie de rotation et ont chacun une largeur radiale qui est supérieure à une largeur radiale de l'anneau de suscepteur (2) ;
la fourniture de la plaquette semi-conductrice (4) ;
le dépôt de la plaquette semi-conductrice (4) sur un rebord (3) de l'anneau de suscepteur (2) dans la zone de bordure d'une face arrière de la plaquette semi-conductrice (4), le fond de suscepteur (1) présentant un nombre de creux (5) qui correspond à un nombre de premières de deux zones partielles alternées de la zone de bordure de la face avant de la plaquette semi-conductrice (4), et un taux de croissance de la couche épitaxiale est plus faible dans les premières zones partielles que dans les secondes zones partielles en raison d'une orientation cristalline de la face avant, de telle sorte que les premières zones partielles se trouvent au-dessus des creux (5) dans le fond du suscepteur (1) ; et
le dépôt de la couche épitaxiale sur la face avant de la plaquette semi-conductrice (4).

2. procédé selon la revendication 1, **caractérisé par** la fourniture d'une plaquette semi-conductrice (4) avec une orientation <100> de la face avant et la mise en place de la plaquette semi-conductrice par l'intermédiaire de quatre évidements (5) dans le fond du suscepteur (1).

3. procédé selon la revendication 1, **caractérisé par** la fourniture d'une plaquette semi-conductrice (4) avec une orientation <110> de la face avant et la mise en place de la plaquette semi-conductrice au-dessus de deux cavités (5) dans le fond du suscepteur (1).

4. Procédé selon l'une quelconque des revendications 1 à 3, **caractérisé par** le fait de placer la plaquette semi-conductrice (4) sur le rebord (3) de telle sorte que le rebord (3) soit recouvert par la plaquette semi-conductrice (4) sur une longueur non inférieure à 0,5 mm et non supérieure à 3 mm.

5. procédé selon la revendication 1, **caractérisé en ce que** les creux (5) dans le fond du suscepteur (1) ont la forme de segments d'anneau circulaire.

6. procédé selon la revendication 5, **caractérisé en ce que** les creux (5) ont un angle au centre α qui n'est pas inférieur à 60° et pas supérieur à 70° ou pas inférieur à 90° et pas supérieur à 110°.

7. Procédé selon la revendication 1, **caractérisé en ce que** la section transversale des cavités (5) dans la direction circonférentielle du fond du suscepteur (1) a un contour qui est en forme de V.

8. Procédé selon la revendication 1, **caractérisé en ce que** la section transversale des cavités (5) dans la direction circonférentielle du fond du suscepteur (1) a un contour qui est en forme de U.

9. Procédé selon la revendication 1, **caractérisé en ce que** la section transversale des cavités (5) dans la direction circonférentielle du fond du suscepteur (1) a un contour qui est trapézoïdal.

10. Plaquette semi-conductrice à couche épitaxiale (4) présentant une planéité locale dans la zone de bord avec une valeur ESFQR maximale non supérieure à 12 nm pour une exclusion de bord de 2 mm, l'épaisseur de la couche épitaxiale étant plus mince dans des premières zones partielles de la zone de bord de la plaquette semi-conductrice à couche épitaxiale (4) que dans des secondes zones partielles de la zone de bord, et des dépôts matriciels (12) sont présents sur la face arrière de la plaquette semi-conductrice (4), grâce auxquels l'épaisseur totale que la plaquette semi-conductrice (4) à couche épitaxiale présente dans les premières zones partielles est adaptée à l'épaisseur totale que la plaquette semi-conductrice (4) à couche épitaxiale présente dans les secondes zones partielles.
